# EUROPEAN PATENT APPLICATION

(11) **EP 2 124 264 A1**
(43) Date of publication of application: **25.11.2009**
(21) Application number: 08156693.7
(22) Date of filing: 21.05.2008
(51) Int. Cl.: H01L 31/18

(54) **Method and apparatus for producing a solar cell module with integrated laser patterning**

(71) Applicant: Applied Materials, Inc., Santa Clara, CA 95054 (US)
(72) Inventor: Wieder, Stephan, 60385, Frankfurt (DE)
(74) Representative: Lang, Christian

(57) **Abstract**

The present invention refers to a method as well as an apparatus for producing a solar cell module having an array of photovoltaic cells on a common substrate, the apparatus comprising at least one treating chamber for depositing a layer on a substrate and at least one laser for patterning the deposited layer, wherein a treating chamber for laser patterning comprising means for setting up technical vacuum conditions is provided for.

## Description

### BACKGROUND OF THE INVENTION

### FIELD OF THE INVENTION

The present invention refers to an apparatus for producing a solar cell module having an array of photovoltaic cells on a common substrate, the apparatus comprising at least one treating chamber for depositing a layer on a substrate and at least one patterning means for patterning the deposited layer. The present invention further refers to an appropriate method for producing a solar cell module.

### PRIOR ART

Energy generation by photovoltaic processes are becoming more and more important; since fossil energy resources like crude oil or natural gas become more and more restricted. Accordingly, great efforts are made to improve solar cell technology.

A lot of different concepts exist with respect to the design of photovoltaic devices or solar cells. All of these concepts are based on a semiconductor junction where charge carriers generated by impinging light are separated so that they can be led away through terminals connected to the semiconductor junction.

The different designs of solar cells comprise single semiconductor junctions like p-n-junctions with a p-doped semiconductor and a n-doped semiconductor adjacent to each other as well as multiple semiconductor junctions like pin-structures or nip-structures. While in the past most solar cells were based on silicon substrates, where respective semiconductor junctions were formed, modern photovoltaic devices are based on the so-called thin film technology. This technology utilizes an insulating substrate, e.g. a glass substrate or a plastic foil, or a metallic substrate onto which different layers are deposited to form an appropriate photovoltaic device. For example, US 6,168,968 B1 and US 6,288,325 B1 describe methods of producing thin film solar cells, where metallic or glass substrates are coated with a front or a back electrode layer, several semiconductor layers of doped and un-doped amorphous or micro-crystalline silicon as well as an appropriate back or front contact layer, respectively. If a glass substrate is used, the front contact may be formed by a transparent conductive oxide TCO, for example formed by indium tin oxide ITO.

WO 2006/053129 A2 describes an apparatus and a method for manufacturing photovoltaic devices by which such layers like a conductive back layer, a p-type semiconductor layer, an n-type semiconductor layer and a transparent conductive front layer can be deposited continuously on a substrate.

Although, the method described in WO 2006/053129 A2 is efficient for producing a layer stack of a solar cell or a photovoltaic structure, the described process may be disadvantageous for an industrially produced solar cell module in terms of efficiency and throughput.

In order to generate a sufficient yield of the electric energy or power generated, it is known in prior art to produce a plurality of separated and independent photovoltaic devices on a common substrate to be connected serially. Such an array of serially connected photovoltaic devices on a common substrate allows combining the electric energy generated in each photovoltaic device in order to increase the output voltage of the solar cell module. For this purpose, it is already known to pattern or to structure the deposited layers of the photovoltaic device, as described in US 6,168,968 B 1, US 6,288,325 B1 and US 5,527,716 A. During patterning or structuring trenches are introduced into the deposited layers in order to produce single areas separated to each other. Accordingly, the separated and independent areas of the successively deposited layers form together single and independent photovoltaic devices which can be appropriately electrically connected to form a solar cell module having a high electrical output.

Patterning, which might also be designated as trenching, is most often performed by a laser beam which is scanned over the surface of the photovoltaic layer structure in order to remove one or more deposited layers and/or parts of the substrate along the movement path of the laser beam. Accordingly, this process is also designated as scribing.

Although, structuring and patterning lead to an improved solar cell module, it is detrimental that this makes the overall production process very laborious and complex.

### DISCLOSURE OF THE INVENTION

### OBJECT OF THE INVENTION

It is therefore an object of the present invention to provide an apparatus as well as a method for producing a solar cell module which avoids the disadvantages of prior art. In particular, the inventive method as well as the inventive apparatus should ensure an efficient and simple process for producing a solar cell module having an array of independent photovoltaic devices on a common substrate while at the same time good quality of the solar cells and especially high output of electrical energy should be reached. Moreover, the apparatus for producing such a solar cell module should be easy to manufacture.

### TECHNICAL SOLUTION

The above-mentioned objects of the present invention are achieved by an apparatus having the features of claim 1 as well as a method having the features of claim 14 or 15. Preferred embodiments are subject matter of the dependent claims.

According to the present invention, it is suggested to carry out the patterning or structuring of a photovoltaic layer structure by laser treatment, maser (microwave amplification by stimulated emission of radiation) treatment, ultrasonic treatment, mechanical cutting or milling or a similar treatment under technical vacuum conditions so that this process step can be integrated into a vacuum apparatus for depositing layers for a photovoltaic layer structure. Accordingly, the patterning step is performed in a treating or vacuum chamber.

The patterning step can be carried out in the same treating chamber in which one or several deposition steps are performed. For example, such a treating chamber may provide different support positions for a substrate to be treated, in which different treating steps may be performed. While such a design is suitable for stationary treatment of the substrate, i.e. the substrate is stationary during single treating steps and/or during several or between successive treating steps, a separate treating chamber for carrying out the patterning step is preferable for continuous or dynamic treatment of the substrate which means that the substrate is moved during a single treatment step and/or between single treatment steps. A separate treating chamber for only carrying out the patterning step is also useful for stationary treatment in order to avoid contamination problems.

The present invention is particularly beneficial with respect to a continuously working apparatus where different treating chambers and the corresponding treating steps are passed one after the other by the substrate to be treated. Such a continuously working apparatus as well as the corresponding method are very advantageous with respect to reduced handling times for the substrate and the improved efficiency and throughput due to reduced locking processes and correspondingly reduced times for evacuation and filling the treating chambers with gas and/or cooling and heating of the substrates.

Thus, an apparatus according to the present invention may be equipped with transporting means for transporting a substrate from a first treating chamber for depositing a layer to a second treating chamber for patterning the deposited layer as well as for moving the substrate through the first and second treating chambers.

Such transporting means may be designed such that a common transport path through the first and second treating chambers or the whole apparatus is provided for, on which the substrate carriers supporting the substrate during movement through the apparatus can be moved in every conceivable manner. For example, sliding movement of the substrate carriers along rails as well as contactless movement achieved by magnetic forces of the substrate carriers may be used. The transporting means may be designed such that continuous movement and/or a stepwise movement can be performed. Moreover, buffer chambers or the like may be provided for.

Accordingly, the substrate carrier for the substrate may be used during the whole movement of the substrate through the apparatus, i.e. the movement through all the different treating chambers of the apparatus. The first treating chamber for depositing a layer as well as the second treating chamber for patterning the layer deposited in the first treating chamber are accordingly disposed such that the substrate can be moved from the first treating chamber to the second treating chamber without leaving the vacuum atmosphere of the apparatus or the treating chambers, respectively. Especially, the first and second treating chambers may be disposed adjacent to each other. Particularly, no time-consuming lock-in and lock-out processes have to be carried out for moving the substrate from the first treating chamber to the second treating chamber. Accordingly, effort with respect to lock-in and lock-out devices can be saved.

According to the simple and effective design of the present invention, a transfer opening may be present in the chamber walls of adjacent treating chambers to allow simple transfer from the substrate from one treating chamber to the other.

Through this common opening of adjacent treating chambers the common transport path may extend.

Due to the design of the very close arrangement of neighbouring treating chambers, the apparatus can be simplified by using common vacuum means for producing technical vacuum conditions in adjacent treating chambers, like the first treating chamber for depositing a layer and the second treating chamber for patterning the layer. Moreover, means for pressure adjustment between the first and the second treating chamber may be provided for, like additional openings, which at the end would allow providing only vacuum means at one of two adjacent treating chambers.

Since for a photovoltaic layer structure several layers have to be deposited, the apparatus may comprise several first treating chambers for depositing different layers and several second treating chambers for patterning these layers. The first and second treating chambers may be disposed alternately in-line. The number of pairs of first and successive second treating chambers may be in a range of one to twenty.

Instead of a sequence of pairs of first and second treating chambers it is also conceivable to design the apparatus such that several first treating chambers are disposed one after the other adjacent to each other with only one second treating chamber at the end of the series of first treating chambers. This is possible, if the patterning can be carried out for more than one layer in a single process step so that several layers deposited one after the other can be removed by a single patterning step.

Furthermore, variations of the design of successive first and second treating chambers may be applied at the end of the apparatus, since a final patterning step may be carried out under normal atmospheric pressure, since at the end of the apparatus one lock-out process has to be carried out anyway. Accordingly, the last patterning step can be carried out under normal atmospheric pressure.

Furthermore, the apparatus may comprise a third treating chamber or several third treating chambers for carrying out a cleaning step, especially after the patterning step. During this cleaning step particles generated during removing of material in the patterning step, which are only loosely adhered to the surface of the substrate, can be removed in order to avoid detrimental effects on the subsequent deposited layers and the photovoltaic device. Accordingly, after each second treating chamber for laser patterning the substrate a third treating chamber for carrying out the cleaning step may be arranged.

This third treating chamber for cleaning the substrate may be disposed along the transport path of the substrate similar to the first and second treating chamber so as to form a row of first, second and third treating chambers. Such a design may be especially useful when the cleaning step in the third treating chamber is also carried out under vacuum conditions.

Alternatively, the third treating chamber can be disposed offset of the transport path of the substrate through the first and second treating chambers. Such a design may be used, if the treating step is not carried out under vacuum conditions, but under normal atmospheric conditions so that in this case additional lock-in and lock-out processes have to be carried out. This can be done very efficiently, if the third treating chamber is not in-line with the first and the second treating chambers, since this place at the transport path may be used for a lock-in and a lock-out chamber.

If the third treating chamber is located in-line with respect to the first and the second treating chambers along the transport path of the substrate through the apparatus, the treating chamber may be designed similar to the first and second treating chambers.

Especially, the whole apparatus may comprise a plurality of identical modules which can be combined with each other and individually equipped according to the specific requirements of the apparatus.

One module may comprise one or several treating chambers, for example a pair of first and second treating chambers or a triple of first, second and third treating chambers.

The treating chambers may be equipped according to the methods and processes which are to be carried out in the treating chambers. For example, deposition of the different layers may be performed by chemical or physical vapor deposition processes CVD or PVD, especially low pressure chemical vapor deposition LPCVD, plasma enhanced chemical vapor deposition PECVD, cathode evaporation also designated as sputtering or reactive cathode evaporation (reactive sputtering).

The second treating chamber, wherein the laser patterning step is carried out, may be equipped with a corresponding device inside the treating chamber or outside of the treating chamber, for example in case a laser is used as patterning means. When the laser device is disposed outside the treating chamber, the treating chamber may comprise a transparent window for the laser irradiation in order to allow the laser beam to be directed onto the substrate to be laser treated.

If the laser or any other patterning means is arranged inside the treating chamber, vacuum feed throughs for supply lines may be provided for.

The cleaning processes carried out in the third treating chamber may comprise different cleaning methods or combinations thereof including fluid cleaning, chemical cleaning, electrostatic cleaning, blow cleaning and suction cleaning. However, some of the cleaning processes may only be carried out under normal atmospheric pressure conditions, while others also can be used under vacuum conditions. For example, electrostatic cleaning using electronic forces for attracting charged particles can also be used in vacuum as blow cleaning or suction cleaning. Blow cleaning uses a stream of inert gas to blow away particles from the surface of the substrate while suction cleaning utilizes suction means to attract particles. Especially, blow cleaning and suction cleaning may be used in combination. Fluid cleaning or chemical cleaning are preferably used under normal atmospheric pressure conditions, since the liquids used during this cleaning process may negatively affect vacuum atmosphere.

At the end of the manufacturing process of a solar cell module the solar cell is encapsulated so that the apparatus may also comprise an encapsulating unit. However, this process may be carried out under normal atmospheric pressure so that no vacuum chamber is necessary for this process.

### SHORT DESCRIPTION OF THE FIGURES

Further advantageous, features and characteristics of the present invention will become apparent from the following description of preferred embodiments of the present invention with respect to the accompanying drawings. The drawings show in a pure schematic way in
- Fig. 1: a top view of an inventive apparatus;
- Fig. 2: a top view of a part of a second embodiment of an inventive apparatus;
- Fig. 3: a side view of a part of a third embodiment of the present invention; and in
- Fig. 4: a top view of a fourth embodiment of the present invention.

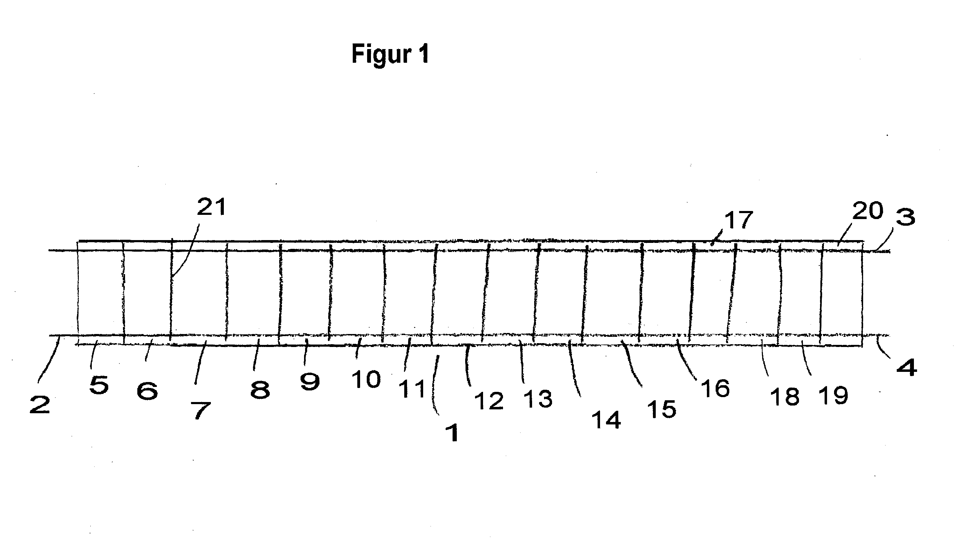

Fig. 1 is a schematic top view on a first embodiment of the present invention. The apparatus 1 shown in fig. 1 comprises a transport path 2 along which the substrates to be treated are moved through the apparatus 1. For this purpose, a transport path 2 may comprise two tracks 3 and 4 which may support a substrate carrier on which the substrates may be supported during movement through the apparatus 1. Accordingly, the substrate carrier may be designed such that the substrate carrier is movable in a gliding way along the tracks 3 and 4. However, other types of movement as well as other types of substrate carriers and transport means are conceivable.

The apparatus 1 comprises 16 chambers which are disposed one after the other along the transport path 2. Accordingly, during operation the substrates to be treated in the apparatus 1 are moved through the chambers 5 to 20 successively.

The first chamber 5 is a lock chamber which allows locking in the substrates to be treated into the apparatus 1. Since the whole apparatus 1 is operated with technical vacuum conditions inside the chambers 6 to 19, the substrates have to run through a lock chamber 5 at the inlet as well as the outlet (lock chamber 20) to be brought from the normal atmospheric pressure outside the apparatus 1 to the near vacuum conditions inside the apparatus 1 and vice versa.

In proximate neighbourhood to the lock-in chamber 5 a first treating chamber 6 is provided for. The treating chamber 6 is designed such so as to allow a deposition of a transparent conductive oxide layer onto the substrate which is preferably a glass substrate. The transparent conducive oxide TCO may be deposited by a sputtering process, especially a reactive sputtering process or Low Pressure Chemical Vapour Deposition LPCVD, so that the treating chamber 6 is equipped with a cathode evaporation device.

The TCO layer deposited in the treating chamber 6 may be an aluminium doped zinc oxide layer, a fluorine doped tin oxide (F-SnO), indium doped tin oxide (ITO) or a similar layer used in photovoltaic industry for making the front contact.

The apparatus 1 is designed to handle large-area substrates in order to produce big-sized solar cell modules. In order to achieve a high electrical output from the solar cell module, such large-area solar cell modules are made of an array of single photovoltaic cells being arranged in rows and columns adjacent to each other on the module. In order to produce such a plurality of separated photovoltaic cells, the layers deposited to form a photovoltaic structure are patterned or structured in order to form trenches in the respective layers so as to separate specific areas forming single photovoltaic cells. Accordingly, this process is also designated as trenching.

Consequently, the apparatus 1 comprises a second treating chamber 7 following successively the first treating chamber 6 along the transport path 2. Accordingly, the first treating chamber and the second treating chamber 7 have a common sidewall 21 with an opening (not shown) through which the substrate is moved along the transport path.

The patterning step in the treating chamber 7 is carried out by a laser process. A laser having a focused laser beam may scan over the surface of the substrate or the layer deposited in the treating chamber 6, respectively, in order to cut a trench into said layer. Accordingly, this process is also designated as scribing a pattern or structure into a surface of the substrate. Instead of moving the laser beam over the surface to be treated the substrate may be moved with respect to the fixed laser beam or combined movement may be carried out. Such a relative movement can also be applied to other patterning methods like mechanical patterning or maser patterning.

During the patterning step in treating chamber 7 the particles removed by laser cutting may be blown away by a blowing gas stream of inert gas directed onto the surface of the substrate to be treated and/or sucked off from the surface of the substrate by suction means. For this purpose, nozzles for blowing inert gas onto the substrate as well as to suck off a surface area of the substrate may also be moved over the surface of the substrate similar to the laser beam. In addition, other cleaning processes may be simultaneously carried out during the patterning step. For example, electrostatic cleaning may be used. For this process, the substrate carrier as well as the substrate are set to a specific electric potential in order to charge the particles removed by the laser beam. Spaced apart from the substrate counter electrodes may be provided to electrically attract the charged particles and thereby remove the loose particles from the substrate.

Alternatively or in addition to the cleaning during the patterning step, a third treating chamber 8 for carrying out a cleaning step may be provided. While the embodiment shown in fig. 1 comprises such a cleaning chamber 8, this is not mandatory. Even the cleaning during patterning is not necessary in every case, if the patterning step under technical vacuum conditions leads to a sufficient clean surface of the substrate.

If a cleaning chamber 8 as in the embodiment shown in fig. 1 is provided for, the same cleaning processes as described before which are suitable for being performed under vacuum conditions may be carried out in the cleaning chamber 8. Therefore, the cleaning chamber 8 may accordingly be equipped.

The next treating chamber 9 being also closely attached to the treating chamber 8 again is a treating chamber of the first type. Accordingly, in the treating chamber 9 a deposition process is carried out. The treating chamber 9 is a CVD chamber wherein a chemical vapor deposition of a first semiconductor layer is carried out. Accordingly, treating chamber 10 is again a treating chamber of the second type in which the layer deposited in the CVD chamber 9 is patterned by a laser treatment. After the laser chamber 10 again a cleaning chamber 11 is disposed as seen in the transport direction of the transport path 2.

Chambers 12 to 14 and 15 to 18 form also triples of chambers like the chambers 9 to 11 comprising a deposition chamber 5, 15 and a laser chamber 13, 16 for trenching the layer deposited before as well as cleaning chambers 14, 17 to remove waste particles of the surface of the substrate.

The deposition chambers 9, 12 and 15 are used to deposite semiconductor layers by chemical vapor deposition CVD or especially plasma enhanced chemical vapor deposition PECVD in order to form a photovoltaic structure. Semiconductor layers deposited in the chambers 9, 12, 15 may be p-doped, n-doped or intrinsic silicon layers, especially hydrogenated silicon layers of amorphous or micro-crystalline type in order to form pin- or nip-structures. However, other types of photovoltaic structures formed of other layer structures or any other suitable semiconductor material, for example semiconductors formed by elements of the groups III/V of the periodic table, are also conceivable. Accordingly, the numbers of deposition chambers as well as successive patterning chambers and cleaning chambers of the apparatus may be adapted to the specific requirements.

For this reason, it is advantageous to design the apparatus 1 as a combination of a plurality of modules, one or more chambers forming one module. Thus, the apparatus 1 can be designed specifically with respect to the solar cell module to be produced by combining the appropriate number of modules. In this respect it is also advantageous to use identical modules or chambers, respectively, as a basic component of the apparatus 1. Such a basic component or chamber can be equipped with the appropriate devices and means so as to form a treating chamber of a first type, a second type or a third type, i.e. a deposition chamber, a patterning chamber or a cleaning chamber.

After the sequence of the chambers for deposition of layers and patterning as well as cleaning of the semiconductor layers (chambers 9 to 17), a further treating chamber of the first type is disposed adjacent to the cleaning chamber 17. The treating chamber 18 serves for producing a back contact layer, which might be a metallic layer, like aluminum.

Subsequent to the treating chamber 18 a treating chamber 19 for patterning of the back contact is provided for.

At the end of the apparatus 1 a lock out chamber 20 is disposed in order to remove the treated substrate or the produced solar cell module from the apparatus 1 by bringing it to the normal atmospheric pressure outside the apparatus 1 without destroying the vacuum conditions being present inside the apparatus 1.

As may be understood from the foregoing description, the whole apparatus 1 comprising treating chambers 6 to 19 is operated under technical vacuum conditions. Accordingly, means for producing such a vacuum (not shown) are provided for. Although, almost the same vacuum conditions may be present during operation in at least some of the treating chambers 6 to 19 of the apparatus 1, the single chambers 6 to 19 are separated by sidewalls 21 in order to enable a module concept and to avoid influences from one treating process carried out in one chamber to another treating process carried out in an adjacent chamber. For this purpose, lock means like shutters or valves or the like may be provided at the openings or transitions between the chambers 6 to 19. However, due to the fact that all different treating processes like deposition process, patterning process and cleaning process are carried out under technical vacuum conditions, it is not necessary to perform time-consuming lock-in and lock-out processes. Accordingly, it is neither necessary to provide additional lock-in and lock-out means which require additional expensive devices and space.

However, some processes are carried out under different vacuum conditions, like CVD processes at pressures in the range of 1 to 10 hPa and sputter processes at pressures in the area of 5 * 10⁻³ hPa. Accordingly, between treating chambers in which such different processes are carried out means for dealing with such pressure differences and/or gas separation means for separating different gas atmospheres have to be provided for. Thus, slit valves or lock-valves may be arranged between treating chambers in which different pressures and/or different gas atmospheres are present during processing of the substrates.

Moreover, buffer chambers (not shown) may be disposed in the apparatus to allow adapting of processing speed in different chambers or parts of the apparatus to each other. Accordingly, buffer chambers may be used to speed down or accelerate the substrates in the continuously working apparatus. In addition, buffer chambers may allow operation of parts of the apparatus for a while during breakdown of other parts to thereby improve efficiency of the apparatus.

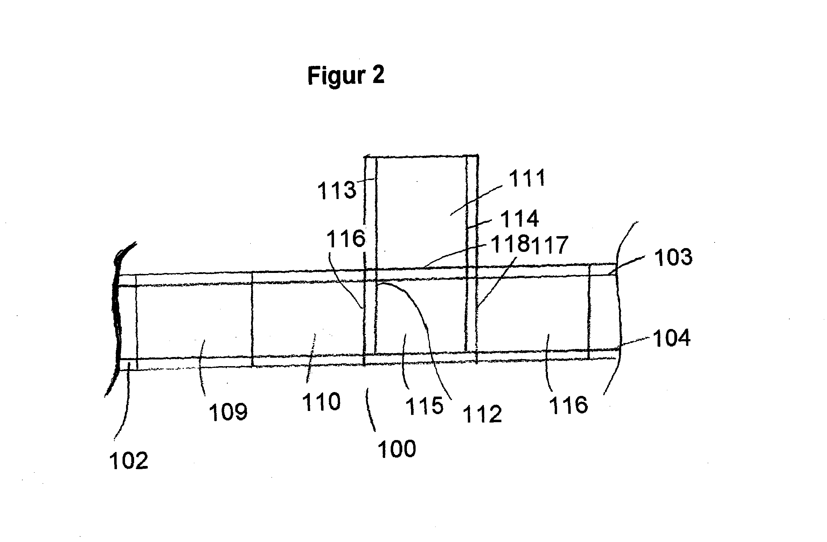

Only in cases, where cleaning of the surface after the patterning step is crucial, a second type of a cleaning chamber or a second kind of arrangement of a cleaning chamber, respectively, may be chosen. An example is shown in fig. 2 showing only a part of an inventive apparatus for producing a solar cell module.

The part of the apparatus 100 shown in fig. 2 discloses a transport path 102 comprising tracks 103 and 104 comparable to the transport path 2 and the tracks 3 and 4 of the embodiment shown in fig. 1.

Further, apparatus 100 comprises a deposition chamber 109 and a patterning chamber 110. Contrary to the embodiment of fig. 1 the cleaning chamber 111 is not disposed along the transport path 102, but offset of the transport path 102 so that adjacent to the patterning chamber 110 a transport chamber 115 is disposed. The transport chamber 115 comprises a second transport path 112 transverse to the transport path 102. The transport path 112 also comprises two tracks 113 and 114 along which the substrate carrier can be slidably moved. The transport path 112 leads into the cleaning chamber 111 disposed offset the row of chambers 109, 110, 115 and 116. Accordingly, the chamber 115 is used as lock-in and lock-out chamber for the cleaning chamber 111. While a substrate is transferred from the patterning chamber 110 to the chamber 115 the transfer opening in the chamber wall 118 between the chambers 115 and 111 is closed so that the pressure in the chamber 115 is equivalent to the pressure in the chambers 110 and 116, respectively. When the substrate is received in chamber 115, shutters at the sidewalls of the chamber 115 being adjacent to the chambers 110 and 116, i.e. sidewalls 116 and 117, are closed and the shutter of sidewall 118 is opened. The substrate in chamber 115 can now be moved into cleaning chamber 111, while at the same time the substrate already cleaned in chamber 111 may be moved to the chamber 115. After transfer of the substrates, the shutter in the sidewall 118 is again closed and the chamber 115 is brought again to vacuum conditions. After reaching vacuum conditions, the shutters in the sidewalls 116 and 117 are opened and the already cleaned substrate being present in the chamber 115 can be moved to the next treating chamber 116. Thus, it is possible to carry out cleaning processes under normal atmospheric pressure conditions in the cleaning chamber 111 instead of cleaning processes under vacuum conditions in the cleaning chambers 8, 11, 14, 17 in the apparatus 1 of fig. 1. However, in the apparatus 100 a still advantageous embodiment is realized, since the patterning step in the patterning chamber 110 is still carried out under vacuum conditions so that additional lock-in and lock-out processes as carried out for chamber 115 are not necessary. Thus, the apparatus 104 shown in the embodiment of fig. 2 is still advantageous over prior art. In the foregoing the lock-in and lock-out processes as well as the cleaning step are described with respect to normal atmospheric pressure conditions. However, instead of normal pressure conditions other pressure conditions may be set.

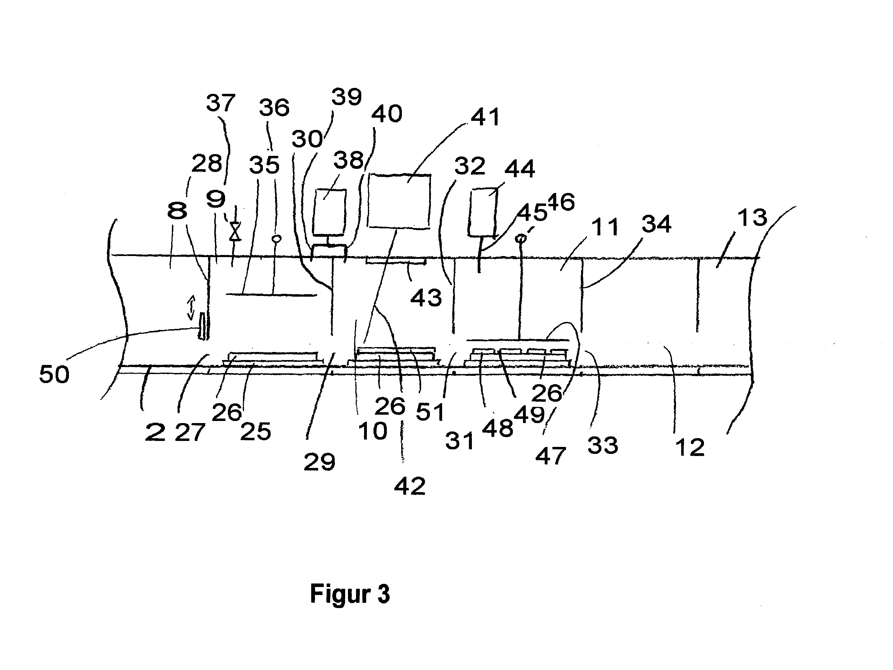

Fig. 3 shows a part of the embodiment shown in fig. 1 in a side view. The partial view of fig. 3 shows the cleaning chamber 8, the deposition chamber 9, the patterning chamber 10, the cleaning chamber 11 as well as a further deposition chamber 12 and a further patterning chamber 13.

The chambers 8, 9, 10, 11, 12 and 13 are separated by chamber walls which comprise transfer openings for the substrates to be moved along the transport path 2. In fig. 3 the chamber walls between the chambers 8 and 9, 9 and 10, 10 and 11 as well as 11 and 12 are designated with the reference numerals 28, 30, 32 and 34. The corresponding transfer openings are designated by reference numerals 27, 29, 31 and 33. The transfer openings may comprise shutters to close the openings as shown for the transfer opening 27 with shutter 50 which is slidably movable along the chamber wall 28. By means of the shutter 50 the chambers 8 and 9 can be separated so as to avoid detrimental influences of the processes carried out in each chamber.

The treating chamber 9 shown in fig. 3 is a chamber designed as a chamber for carrying out a plasma enhanced chemical vapor deposition PECVD. For this purpose, an electrode 35 connected to an RF (radio frequency) power supply 36 is disposed in the chamber. As the counter electrode the substrate carrier 25 carrying substrate 26 may be used. The carrier 25 is therefore grounded. Due to the RF power supply applied to the electrode 35, a plasma may be ignited between the electrode 35 and the substrate 26 when the process gas like argon is introduced through the gas supply 27 to the treating chamber 9. In addition, reactive gases like silane, disilane or trimethylboron for depositing a semiconductor layer may be introduced to the gas supply 37.

In order to achieve technical vacuum conditions a vacuum pump 38 which is serving for the adjacent chambers 9 and 10 is provided. The vacuum pump 38 is connected to the chambers 9 and 10 by conducting pipes 39 and 40. Instead of a common conduction pipe for adjacent chambers, like chamber 9 and 10, each chamber may have a separate vacuum pump as shown with the vacuum pump 44 and the conduction pipe 45 for the chamber 11.

After depositing a semiconductor layer 51 in the treating chamber 9 the substrate 26 is moved to the chamber 10 wherein a patterning or structuring of the layer 51 is performed. For this purpose, a laser device 41 is disposed outside the vacuum chamber 10. The laser device 41 produces a focused laser beam 42 which is directed to the surface of the substrate 26 or the layer 51, respectively. For this purpose, a window 43 being transparent for the laser light produced by the laser device 41 is disposed in the respective sidewall of the chamber 10.

The laser light beam 42 is moved over the surface of the substrate 26 in order to produce trenches 49 shown for the substrate 26 disposed in the chamber 11. By the trenches 49 the layer 51 is divided into separate areas to form separate photovoltaic cells on a common substrate 26.

The chamber 11 serves for cleaning of the substrate 26 as well as of the trenches 49 and the layer areas 48 produced in the preceding chambers 9 and 10. The cleaning process performed in the cleaning chamber 11 is an electrostatic cleaning. The substrate carrier 25 is connected to an electrical voltage source 46 so that the substrate carrier as well as the substrate 26 and all particles adhered to the surface of the substrate 26 are set to a first potential. The counter electrode 47 which is also connected to the power supply 46 is set to a second potential opposite to the first potential so that the particles electrically charged are attracted to the counter electrode 47. Accordingly, the surface of the substrate 26 is cleaned.

Although, the deposition chamber 9, the patterning chamber 10 and the cleaning chamber 11 are described with respect to specific processes, it is clear for a man skilled in the art that other processes suitable for producing appropriate photovoltaic cells or solar cell modules may be performed in correspondingly equipped treating chambers.

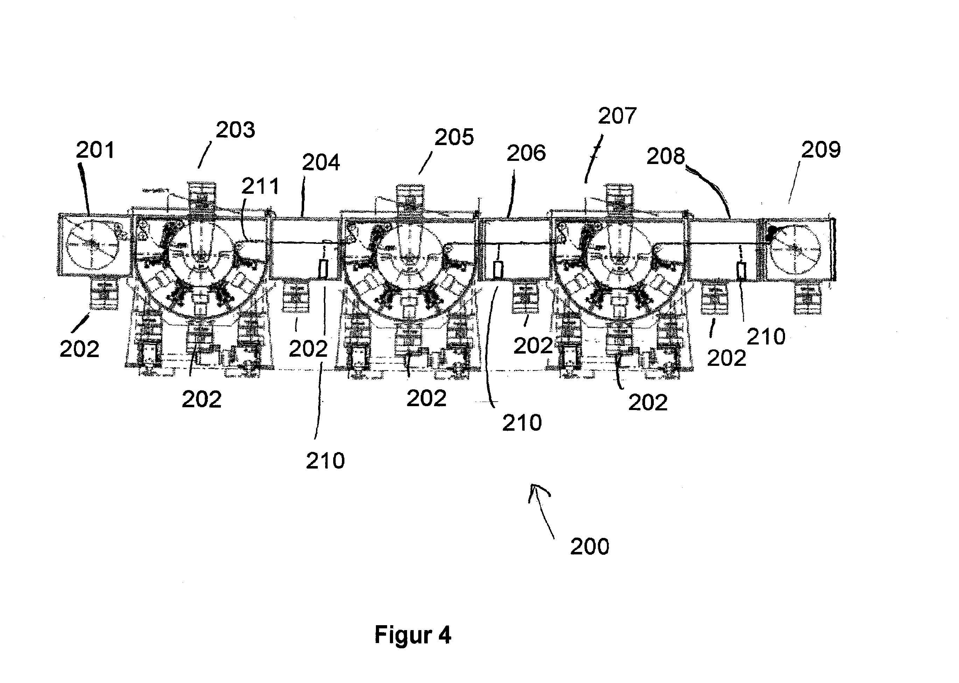

A further embodiment of the present invention is shown with respect to fig. 4. Fig. 4 discloses an apparatus for producing a flexible solar cell module on a flexible isolating substrate such as a plastic foil. The substrate formed of a flexible band or foil is also designated as a web and therefore the apparatus is also called a web coating apparatus. Such an apparatus 200 comprises a roll-off chamber 201 where the foil roll with the uncoated substrate is received to be rolled off. Adjacent to the roll-off chamber 201 a first coating chamber 203 is arranged in which the transparent web is coated with a transparent conductive oxide file to form the front contact layer. After the first coating chamber the web 211 is introduced into a first patterning chamber 204 in which a laser 210 is arranged for carrying out a patterning step. Since the first patterning chamber 204 is arranged directly adjacent to the first coating chamber 203, the band or web 211 to be coated does not have to leave vacuum, since vacuum conditions are set both in the first coating chamber 203 and the first patterning chamber 204.

After patterning of the transparent conductive oxide layer or front contact layer a second coating chamber 205 for depositing the absorber layers or solar cell structure is provided for. Instead of one second coating chamber 205 as shown in fig. 4 several coating chambers 205 for depositing a series of layers for the absorber or solar cell structure may be arranged one after the other. After each second coating chamber 205 or after several or the series of second coating chambers 205 a second patterning chamber 206 is disposed which is similar to the first patterning chamber 204. The second patterning chamber 206 also comprises a laser 210 for cutting trenches into the deposited layers in order to separate individual solar cell devices.

The apparatus 200 of fig. 4 further comprises a third coating chamber 207 for depositing a metallic back contact layer which can also be patterned in the following third patterning chamber 208. For this reason, a laser 210 is arranged in the third patterning chamber 208. At the end of the apparatus a roll-on chamber for winding of the coated web is arranged.

As can be seen from fig. 4, the web coating apparatus 200 comprises several vacuum pumps 202 in order to produce and maintain vacuum conditions throughout the whole apparatus 200. Especially, for each chamber 201, 203, 204, 205, 206, 207, 208 and 209 respective vacuum pumps 202 are provided for. However, it is also possible that adjacent vacuum chambers use common means for producing vacuum conditions.

The embodiment of fig. 4 shows that the present invention cannot only be used for producing thin film solar cells on isolating or metallic rigid substrates like glass plates, but also on flexible isolating or metallic substrates. While the embodiment shown in fig. 4 is designed for producing flexible solar cell modules on flexible, transparent substrates like plastic foils, a similar design can be set up for depositing solar cells on non-transparent, flexible substrates as metallic foils.

When a metallic substrate is used, the layer sequence which has to be deposited is different to the layer sequence deposited on isolating, transparent substrates. For metallic substrates first of all an isolating layer may be deposited onto which a conductive layer as back contact may be coated. On the back contact the absorber layers or a layer stack for generating a photovoltaic device is provided for. The closing layer is a front contact formed from transparent conductive material like transparent conductive oxide. In addition to the transparent conductive oxide a contact structure made by screen printing may be applied.

In case of a transparent substrate, a patterning of the deposited layers can be carried out from both sides of the substrate, while for non-transparent substrates a patterning is carried out from the side where the layers are deposited. Accordingly, the laser or other suitable means for patterning may be arranged at different positions within the vacuum chamber with respect to the substrate.

Although, the present invention is described in detail with respect to the embodiments, it is evident for a man skilled in the art, that the invention is not restricted to these embodiments, but modifications and amendments are possible, with respect to a different combination of all the features disclosed in the specification or by omitting one of the features of the embodiments without leaving the scope of the present invention which is defined by the attached claims. In particular, the present invention comprises all possible combinations of all claims, even if single claims are only referred to other single claims.

The invention is especially defined by the following features:
1. Apparatus for producing a solar cell module having an array of photovoltaic cells on a common substrate, comprising at least one treating chamber for depositing a layer on a substrate and at least one patterning for patterning the deposited layer,
   wherein
   a treating chamber for patterning comprising means for setting up technical vacuum conditions is provided for.
2. Apparatus according to feature 1,
   **wherein**
   a first treating chamber for depositing a layer and a second treating chamber for patterning the deposited layer are different treating chambers.
3. Apparatus according to feature 1,
   **wherein**
   a first treating chamber for depositing a layer and a second treating chamber for patterning the deposited layer are realized by the same treating chamber.
4. Apparatus according to feature 1,
   **wherein**
   transporting means are provided for transporting a substrate from a first treating chamber for depositing a layer to a second treating chamber for patterning the deposited layer and through the first and second treating chambers.
5. Apparatus according to feature 4,
   **wherein**
   the transporting means comprise a common transport path through the first and the second treating chamber.
6. Apparatus according to feature 4,
   **wherein**
   the substrate is supported by a substrate carrier used during movement through the first and the second treating chamber.
7. Apparatus according to feature 2,
   **wherein**
   a first treating chamber for depositing a layer and a second treating chamber for patterning the layer deposited in the first treating chamber are arranged adjacent to each other with a common opening in between through which a common transport path of the substrate is extending.
8. Apparatus according to feature 2,
   **wherein**
   a first treating chamber for depositing a layer and a second treating chamber for patterning the layer have common vacuum means for producing technical vacuum conditions.
9. Apparatus according to feature 2,
   **wherein**
   a first treating chamber for depositing a layer and a second treating chamber for patterning the layer comprise means for pressure equilibrium between first and second treating chamber.
10. Apparatus according to feature 1,
   **wherein**
   several first treating chambers for depositing different layers and several second treating chambers for patterning these layers are provided.
11. Apparatus according to feature 10,
   **wherein**
   first and second treating chambers are alternately arranged in line.
12. Apparatus according to feature 10,
   **wherein**
   along a common transport path for a substrate n pairs of first and successive second treating chambers with n being an integer between 1 and 20 and a last first or second treating chamber are arranged.
13. Apparatus according to feature 1,
   **wherein**
   at least one third treating chamber is arranged for cleaning the substrate.
14. Apparatus according to feature 13,
   **wherein**
   the third treating chamber is arranged after a second treating chamber.
15. Apparatus according to feature 13,
   **wherein**
   several third treating chambers are arranged each after a second treating chamber.
16. Apparatus according to feature 13,
   **wherein**
   the third treating chamber is arranged along the transport path of the substrate through the first and second treating chambers in a row after the first and second treating chamber.
17. Apparatus according to feature 13,
   **wherein**
   the third treating chamber is arranged with respect to the transport path of the substrate through the first and second treating chambers in a branch thereto.
18. Apparatus according to feature 16,
   **wherein**
   the third treating chamber comprises at least part of the same transporting means for transporting a substrate as first treating and second treating chambers.
19. Apparatus according to feature 16,
   **wherein**
   the third treating chamber for cleaning the substrate is arranged adjacent to another treating chamber with a common opening in between through which a common transport path of the substrate is extending.
20. Apparatus according to feature 16,
   **wherein**
   the third treating chamber and another treating chamber have common vacuum means for producing technical vacuum conditions.
21. Apparatus according to feature 1,
   **wherein**
   the first treating chamber is equipped such that at least one of the treatments of the group comprising physical vapour deposition PVD, chemical vapour deposition CVD, low pressure chemical vapour deposition LPCVD, plasma enhanced chemical vapour deposition PECVD, cathode evaporation (sputtering) and reactive cathode evaporation (reactive sputtering) can be performed.
22. Apparatus according to feature 1,
   **wherein**
   the treating chamber for patterning is equipped such that the patterning can be performed by at least one out of the group comprising a laser, a maser, a ultrasonics device, a scarificator, and a gouge, the patterning means cutting trenches into the substrate and the layers deposited thereon.
23. Apparatus according to feature 1,
   **wherein**
   the second treating chamber comprises a laser arranged inside the treating chamber.
24. Apparatus according to feature 1,
   **wherein**
   the second treating chamber comprises a window being transparent for laser light, the laser being arranged outside the treating chamber such that the substrate can be irradiated by the laser light through the window.
25. Apparatus according to feature 1,
   **wherein**
   a sputter deposition chamber for depositing transparent conductive oxide TCO, a laser chamber for patterning the TCO layer, several CVD chambers for depositing semiconductor layers followed by one common laser chamber at the end of a row of several CVD chambers for patterning a layer stack or several laser chambers each after a CVD chamber for patterning each single layer deposited by the CVD chambers and a sputter deposition layer for depositing a back contact layer are provided for.
26. Apparatus according to feature 16,
   **wherein**
   the third treating chamber is equipped such that at least one of the treatments of the group comprising fluid cleaning, chemical cleaning, electrostatic cleaning, blow cleaning and suction cleaning can be performed.
27. Apparatus according to feature 1,
   **wherein**
   an encapsulating unit is provided at the end of a transport path through the apparatus.
28. Method for producing a solar cell module having an array of photovoltaic cells on a common substrate, comprising several steps of depositing various layers and several steps of patterning the deposited layers to form a plurality of separated photovoltaic cells in an array,
   **wherein**
   the step of patterning the deposited layer is carried out under technical vacuum conditions.
29. Method for producing a solar cell module having an array of photovoltaic cells on a common substrate, comprising several steps of depositing various layers and several steps of patterning the deposited layers to form a plurality of separated photovoltaic cells in an array,
   **wherein**
   the substrate is kept under vacuum conditions defined by a pressure below atmospheric pressure during at least one depositing step and at least one successive patterning step without leaving vacuum area.
30. Method according to feature 27 or 28,
   **wherein**
   the pressure is set substantially equal during the deposition step and the patterning step.
31. Method according to feature 27 or 28,
   **wherein**
   the deposition step is carried out by at least one treatment out of the group comprising physical vapour deposition PVD, chemical vapour deposition CVD, low pressure chemical vapour deposition LPCVD, plasma enhanced chemical vapour deposition PECVD, cathode evaporation (sputtering) and reactive cathode evaporation (reactive sputtering).
32. Method according to feature 27 or 28,
   **wherein**
   the patterning step is carried out by trenching of at least one out of the substrate and the deposited layers by means of at least one out of the group comprising laser beam treatment, maser beam treatment, ultrasonic treatment, mechanical cutting and milling.
33. Method according to feature 28 or 29,
   **wherein**
   a cleaning step is carried out after the patterning step.
34. Method according to feature 28 or 29,
   **wherein**
   the cleaning step is carried out under technical vacuum conditions.
35. Method according to feature 28 or 29,
   **wherein**
   the cleaning step is carried out under normal atmospheric pressure.
36. Method according to feature 34,
   **wherein**
   the cleaning step comprises at least one of the treatments of the group comprising electrostatic cleaning, blow cleaning and suction cleaning.
37. Method according to feature 33,
   **wherein**
   the cleaning step comprises at least one of the treatments of the group comprising fluid cleaning, chemical cleaning, electrostatic cleaning, blow cleaning and suction cleaning.
38. Method according to feature 28 or 29,
   **wherein**
   an apparatus according to feature 1 is used.

## Claims

1. Apparatus for producing a solar cell module having an array of photovoltaic cells on a common substrate, comprising at least one treating chamber for depositing a layer on a substrate and at least one patterning means for patterning the deposited layer,
**wherein**
a treating chamber for patterning comprising means for setting up technical vacuum conditions is provided for.

2. Apparatus according to claim 1,
**wherein**
a first treating chamber for depositing a layer and a second treating chamber for patterning the deposited layer are different treating chambers.

3. Apparatus according to claim 1,
**wherein**
a first treating chamber for depositing a layer and a second treating chamber for patterning the deposited layer are realized by the same treating chamber.

4. Apparatus according to claim 1,
**wherein**
transporting means are provided for transporting a substrate from a first treating chamber for depositing a layer to a second treating chamber for patterning the deposited layer and through the first and second treating chambers.

5. Apparatus according to claim 2,
**wherein**
a first treating chamber for depositing a layer and a second treating chamber for patterning the layer have common vacuum means for producing technical vacuum conditions.

6. Apparatus according to claim 1,
**wherein**
several first treating chambers for depositing different layers and several second treating chambers for patterning these layers are alternately arranged in line.

7. Apparatus according to claim 1,
**wherein**
at least one third treating chamber is arranged after a second treating chamber for cleaning the substrate.

8. Apparatus according to claim 1,
**wherein**
the first treating chamber is equipped such that at least one of the treatments of the group comprising physical vapour deposition PVD, chemical vapour deposition CVD, low pressure chemical vapour deposition LPCVD, plasma enhanced chemical vapour deposition PECVD, cathode evaporation (sputtering) and reactive cathode evaporation (reactive sputtering) can be performed.

9. Apparatus according to claim 1,
**wherein**
the treating chamber for patterning is equipped such that the patterning can be performed by at least one out of the group comprising a laser, a maser, a ultrasonic device, a scarificator and a gouge, the patterning means cutting trenches into at least one of the substrate and the layers deposited thereon.

10. Apparatus according to claim 1,
**wherein**
the second treating chamber comprises a laser arranged inside the treating chamber.

11. Apparatus according to claim 1,
**wherein**
a sputter deposition chamber for depositing transparent conductive oxide TCO, a laser chamber for patterning the TCO layer, several CVD chambers for depositing semiconductor layers followed by one common laser chamber at the end of a row of several CVD chambers for patterning a layer stack or several laser chambers each after a CVD chamber for patterning each single layer deposited by the CVD chambers and a sputter deposition layer for depositing a back contact layer are provided for.

12. Apparatus according to claim 7,
**wherein**
the third treating chamber is equipped such that at least one of the treatments of the group comprising fluid cleaning, chemical cleaning, electrostatic cleaning, blow cleaning and suction cleaning can be performed.

13. Apparatus according to claim 1,
**wherein**
an encapsulating unit is provided at the end of a transport path through the apparatus.

14. Method for producing a solar cell module having an array of photovoltaic cells on a common substrate, comprising several steps of depositing various layers and several steps of patterning the deposited layers to form a plurality of separated photovoltaic cells in an array,
**wherein**
the step of patterning the deposited layer is carried out under technical vacuum conditions.

15. Method for producing a solar cell module having an array of photovoltaic cells on a common substrate, comprising several steps of depositing various layers and several steps of patterning the deposited layers to form a plurality of separated photovoltaic cells in an array,
**wherein**
the substrate is kept under vacuum conditions defined by a pressure below atmospheric pressure during at least one depositing step and at least one successive patterning step without leaving vacuum area.

16. Method according to claim 14 or 15,
**wherein**
the patterning step is carried out by trenching of at least one out of the substrate and the deposited layers by means of at least one out of the group comprising laser beam treatment, maser beam treatment, ultrasonic treatment, mechanical cutting and milling.
